# EUROPEAN PATENT APPLICATION

(11) **EP 2 849 274 A1**
(43) Date of publication of application: **18.03.2015**
(21) Application number: 13787496.2
(22) Date of filing: 01.02.2013
(51) Int. Cl.: H01M 10/48, G01R 31/36, H02J 7/00

(54) **STORAGE BATTERY MANAGEMENT DEVICE, STORAGE BATTERY MANAGEMENT METHOD, AND PROGRAM**

(30) Priority: 11.05.2012 JP 2012109826
(71) Applicant: Panasonic Intellectual Property Management Co., Ltd., Osaka-shi, Osaka 540-6207 (JP)
(72) Inventor: TAMURA, Hideki, Osaka-shi Osaka 540-6207 (JP); NAKAHARA, Masayuki, Osaka-shi Osaka 540-6207 (JP)
(74) Representative: Appelt, Christian W.
(86) International application number: PCT/JP2013/000549
(87) International publication number: WO 2013/168323

(57) **Abstract**

A storage battery management device includes a demand management unit, a reference value adjusting unit and an output unit in addition to a capacity measuring unit for measuring a full-charge capacity of a storage battery. The demand management unit is configured to obtain demand energy to be charged in the storage battery during a predetermined time period based on at least discharged energy of the storage battery during the predetermined time period. A reference value is dynamically set to the reference value adjusting unit based on the demand energy. The output unit is configured to compare the full-charge capacity and the reference value, and judge that the storage battery is at an end of its life if the full-charge capacity is equal to or less than the reference value and then to output a notification signal.

## Description

### Technical Field

The invention relates to a storage battery management device, a storage battery management method and a program, for managing a lifetime of a storage battery.

### Background Art

For example, JP Pub. No. 2000-285968 (hereinafter referred to as "Document 1") discloses technology for deciding a degraded state of a storage battery to notify a replacement time thereof (see paragraphs [0023], [0031] and [0074] in Document 1). Assumed technology in Document 1 is used for a lead storage battery which a car is equipped with, and voltage, current, temperature, water level, discharge and charge, residual capacity and the like are stored as usage status in a usage status history storage unit in order to judge the degraded state. Storage battery's internal resistivity, discharge rate, temperature rise rate and the like are obtained from the history stored in the usage status history storage unit. The replacement time of the storage battery is judged whether or not any of the storage battery's internal resistivity, discharge rate and temperature rise rate exceeds a corresponding reference value.

The technology described in Document 1 compares the internal resistivity, discharge rate and temperature rise rate with respective reference values in order to judge the replacement time of the storage battery. Each reference value is set to a fixed value so that the replacement time of the storage battery is judged under an identical condition. For example, the replacement time is notified if a state that a full-charge capacity of the storage battery is a half or less than a rated value thereof continues ten times or more and the full-charge capacity is equal to or less than a preset threshold of the storage battery.

Storage batteries are incidentally used not only for vehicles but also as power supplies for portable devices (computers, information terminals, electric tools and the like) and also as auxiliary power supplies in consumer facilities of commercial power supplies.

Examples of applications in the consumer facilities of commercial power supplies include an application in which charged power of a storage battery is used in order to suppress purchase of electric energy when energy consumption is increased, and an application in which backup by a storage battery is performed when a commercial power supply stops supplying electric power. A storage battery may be used in order to solve mismatching between generated electric energy by a photovoltaic power generator and energy consumption in a consumer facility. In this case, the storage battery is charged by surplus power of the electric power generation of the photovoltaic power generator, and the charged power of the storage battery is discharged when the energy consumption in the consumer facility exceeds the generated electric energy of the photovoltaic power generator. Thus, by using the storage battery, generated electric power by the photovoltaic power generator can be consumed without waste.

As described above, storage batteries are used for various applications, but the storage batteries differ in charged energy and discharged energy from each other among users. In other words, it is conceivable that required full charging capacities of storage batteries differ from each other among users thereof. As stated above, the technology described in Document 1 however uses reference values for judging a lifetime of the storage battery, each of which is uniform regardless of users. That is, if a lifetime of a storage battery is judged by such reference values each of which is uniform regardless of users like the technology described in Document 1, excess and deficiency depending on a user may occur in a full-charge capacity of the storage battery when degradation of the storage battery advances.

For example, in a case where a consumer facility requires a little charged energy of a storage battery during a predetermined time period, even if the storage battery can still continue to be used after a full-charge capacity thereof is equal to or less than the reference value owing to degradation thereof, replacement of the storage battery is to be invited. At this time, if the storage battery is replaced, a user thereof may suffer an economic loss. On the other hand, in a case where a consumer facility requires much charged energy of a storage battery during a predetermined time period, even if a full-charge capacity thereof exceeds the reference value, shortage may occur in electric energy which can be stored in the storage battery. Accordingly, waiting until the full-charge capacity is equal to or less than the reference value causes a problem that an effect to be expected by using the storage battery cannot be obtained.

### Summary of Invention

It is an object of the present invention to provide a storage battery management device which enables changing a reference for judging a life time of a storage battery in response to usage status of the storage battery, and to notify the lifetime of the storage battery at timing suitable for the usage status. It is also an object of the present invention to provide a storage battery management method for the storage battery management device, and a program which makes a computer function as the storage battery management device.

In order to achieve the aforementioned object, a storage battery management device of the present invention includes a capacity measuring unit (101), a demand management unit (104), a reference value adjusting unit (102) and an output unit (103). The capacity measuring unit (101) is configured to measure a full-charge capacity of a storage battery (11). The demand management unit (104) is configured to obtain demand energy to be charged in the storage battery (11) during a predetermined time period based on at least discharged energy within charged energy and discharged energy of the storage battery (11) during the predetermined time period. The reference value adjusting unit (102) is configured so that a reference value is dynamically set thereto based on the demand energy obtained through the demand management unit (104). The output unit (103) is configured to compare the full-charge capacity measured with the capacity measuring unit (101) and the reference value set to the reference value adjusting unit (102). The output unit is also configured to judge that the storage battery (11) reaches an end of its life if the full-charge capacity is equal to or less than the reference value, and then to output a notification signal.

In an embodiment, the demand management unit (104) includes a power measuring unit (1041), a history storage unit (1042) and a demand estimation unit (1043). The power measuring unit (1041) is configured to obtain a time change in a residual of the storage battery (11) from the charged energy and the discharged energy of the storage battery (11) during the predetermined time period. The history storage unit (1042) is configured to store information of the time change in the residual of the storage battery obtained through the power measuring unit (1041). The demand estimation unit (1043) is configured to obtain the demand energy from the information of the time change in the residual of the storage battery stored in the history storage unit (1042).

In an embodiment, the demand estimation unit (1043) is configured to obtain, as the demand energy, a difference between a greatest value and a smallest value of the residual of the storage battery during the predetermined time period.

In an embodiment, the storage battery management device is adapted to an application in which a charging time period and a discharging time period of the storage battery (11) during the predetermined time period are divided. The demand management unit (104) is configured to obtain, as the demand energy, a total amount of discharged energy of the storage battery (11) during the discharging time period of the storage battery (11) within the predetermined time period.

In an embodiment, the demand energy for determining the reference value is a daily average value of discharged energy of the storage battery (11) within a prescribed target period.

In an embodiment, the storage battery management device further includes a capacity determination unit (105) configured to determine the full-charge capacity of the storage battery required for a user based on the demand energy obtained through the demand management unit (104). The output unit (103) includes a function for showing the full-charge capacity of the storage battery (11) determined with the capacity determination unit (105).

A storage battery management method of the present invention is a storage battery management method for a storage battery management device configured to manage a lifetime of a storage battery (11). The storage battery management method includes: obtaining demand energy for charging a storage battery (11) during a predetermined time period based on at least discharged energy within charged energy and discharged energy of the storage battery (11) during the predetermined time period; dynamically setting a reference value based on the demand energy; and comparing an estimated full-charge capacity of the storage battery (11) and the reference value, and judging that the storage battery (11) is at an end of its life if the full-charge capacity is equal to or less than the reference value and then to output a notification signal.

A program of the present invention is a program for making a computer function as a storage battery management device including a capacity measuring unit (101), a demand management unit (104), a reference value adjusting unit (102) and an output unit (103). The capacity measuring unit (101) is configured to measure a full-charge capacity of a storage battery (11). The demand management unit (104) is configured to obtain demand energy to be charged in the storage battery (11) during a predetermined time period based on at least discharged energy within charged energy and discharged energy of the storage battery (11) during the predetermined time period. The reference value adjusting unit (102) is configured so that a reference value is dynamically set thereto based on the demand energy obtained through the demand management unit (104). The output unit (103) is configured to compare the full-charge capacity measured with the capacity measuring unit (101) and the reference value set to the reference value adjusting unit (102). The output unit is also configured to judge that the storage battery (11) is at an end of its life if the full-charge capacity is equal to or less than the reference value and then to output a notification signal. The present invention is not limited to the program. For example, the present invention may be a computer readable medium that stores the program.

In the configuration of the present invention, it is possible to notify a lifetime of a storage battery at timing suitable for usage status by enabling changing a reference for judging the lifetime in response to usage status of the storage battery. That is, by judging the lifetime in response to the usage status of the storage battery, the lifetime of the storage battery can be adequately notified at timing without excess and deficiency for a user based on the full-charge capacity of the storage battery.

### Brief Description of Drawings

Preferred embodiments of the invention will now be described in further details. Other features and advantages of the present invention will become better understood with regard to the following detailed description and accompanying drawings where:
FIG. 1 is a block diagram of an embodiment of the present invention
FIG. 2 is a view illustrating degradation of a storage battery;
FIG. 3 illustrates information stored in a history storage unit in the embodiment; and
FIG. 4 is a flow chart depicting an operation example of the embodiment.

### Description of Embodiments

An embodiment is hereinafter explained, for example, as a power storage device used for a detached residence. Technology described in the embodiment can be however applied to other buildings such as an apartment building, an office building, a commercial building, a hospital and a museum. The embodiment exemplifies a power storage device used for a consumer facility of a commercial power supply, but technology to be described below can be employed even in a case where the power storage device is employed as a power supply for electric tools and personal computers. In short, the technology explained in the embodiment can be applied if a lifetime of a storage battery needs to be notified when the storage battery is used.

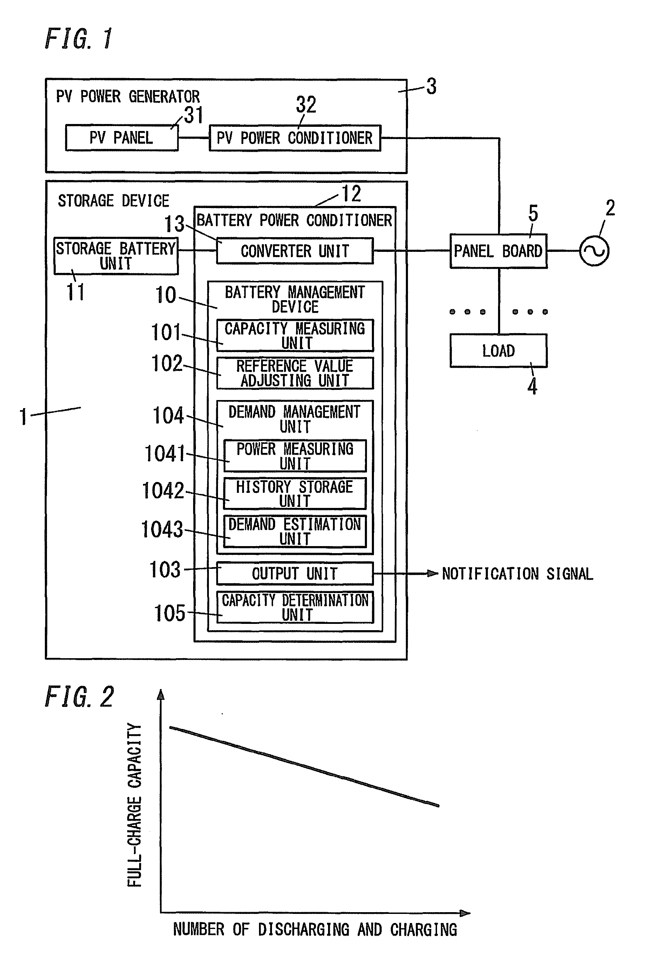

As shown in FIG. 1, a power storage device 1 in the embodiment is used along with an electric power system 2 of a commercial power supply and a photovoltaic power generator 3 in order to supply electric power to loads (devices) 4. The power storage device 1, the electric power system 2 and the photovoltaic power generator 3 are connected to each other through a panel board 5, and electric power is supplied to each load 4 from the panel board 5. The panel board 5 includes one main breaker (not shown) and branch breakers (not shown) as is well known.

The photovoltaic power generator 3 includes a photovoltaic panel (hereinafter referred to as a "PV panel") 31 configured to receive sunlight to generate electricity, and a PV power conditioner (hereinafter referred to as a "PV-PC") 32 configured to convert an output power of the PV panel 31 into AC power. The PV panel 31 and the PV-PC 32 may include known configurations and functions and are not explained in detail because of options.

The power storage device 1 includes a storage battery unit 11 including two or more storage battery cells (not shown), and a power converter (hereinafter referred to as a "battery power conditioner") 12 configured to discharge and charge the storage battery unit 11. In the storage battery unit 11, one case houses, in addition to the storage battery cells (hereinafter referred to as the "storage battery"), a temperature sensor (not shown) for detecting (measuring) storage battery's temperature, a voltage detector (not shown) for detecting (measuring) an open-circuit voltage of the storage battery, a current sensor (not shown) for detecting (measuring) a discharge or charge current, and the like. The battery power conditioner 12 includes: a converter unit 13 including a power conversion function from AC into DC and a power conversion function from DC into AC; and a battery management device 10 configured to control an operation of the converter unit 13 based on respective information obtained from the storage battery unit 11 and the panel board 5.

The way in which the power storage device 1 is actually used depends on specifications of the battery management device 10 built in the power storage device 1. The battery management device 10 includes, as main hardware elements, an interface unit and a device configured to operate in accordance with a program like a microcomputer. The usage of the power storage device 1 is therefore decided by a combination of a program and a kind of input or output information through the interface unit. Examples of usage applications of the power storage device 1 include:
(1) The power storage device 1 is charged for a time period during which a unit price of electricity from the electric power system 2 is a low price, while the power storage device 1 supplies electricity to loads 4 for a time period during which a unit price of electricity from the electric power system 2 is a high price;
(2) The power storage device 1 is charged for a time period during which a unit price of electricity from the electric power system 2 is a low price, while during generation of electricity by the photovoltaic power generator 3 the power storage device 1 supplies electricity to loads 4 and electricity generated by the photovoltaic power generator 3 is allowed to flow back to the electric power system 2;
(3) The power storage device 1 is charged by surplus power, consumed by no load 4, of power generated by the photovoltaic power generator 3, while the power storage device 1 supplies electricity to loads 4 if power consumption by the loads 4 exceeds the electric power generated by the photovoltaic power generator 3;
(4) The power storage device 1 is charged by at least one of the electric power system 2 and the photovoltaic power generator 3, while the power storage device 1 supplies electricity to loads 4 to reduce electric energy to be purchased from the electric power system 2 when electric energy consumed by the loads 4 increases; and
(5) The power storage device 1 is charged by at least one of the electric power system 2 and the photovoltaic power generator 3, while the power storage device 1 supplies electricity to all or part of loads 4 when the electric power system 2 stops supplying electricity.

The aforementioned usage applications of the power storage device 1 are just examples, and the power storage device 1 can be used for various applications by a combination of timing and a kind of a power supply, for charging the power storage device 1, as well as timing for supplying electricity from the power storage device 1 to the loads 4. For example, a program for making a computer function as the battery management device 10 is stored in a computer readable medium (a storage media such as a storage device in the battery management device or a microcomputer).

The battery management device 10 includes a function in response to a usage application of the power storage device 1 as stated above. In the embodiment, a function for managing a lifetime of a storage battery, which the storage battery unit 11 is equipped with, of functions of the battery management device 10 is mainly explained. In the embodiment, when the storage battery cells which the storage battery unit 11 is equipped with, namely the storage battery is at an end of its life, not the storage battery in the power storage device 1 is replaced but the storage battery unit 11 is replaced. In this case, it is desirable that the storage battery unit 11 with a built-in storage battery which is at an end of its life be reused by battery replacement at a collection place or be dismantled and recycled at a collection place. Mainly a function for the storage battery in the storage battery unit 11 is hereinafter explained. Since the storage battery unit 11 corresponds to the storage battery, the storage battery unit 11 is referred to as the "storage battery 11".

As a configuration for managing the lifetime of the storage battery 11, the battery management device 10 includes a capacity measuring unit 101 configured to measure a full-charge capacity of the storage battery 11, a reference value adjusting unit 102 configured so that a reference value is set thereto, and an output unit 103 configured to output a notification signal if the full-charge capacity is equal to or less than the reference value. That is, the output unit 103 is configured to compare the full-charge capacity of the storage battery 11 measured with the capacity measuring unit 101 and the reference value set to the reference value adjusting unit 102, and to judge that the storage battery 11 is at an end of its life if the full-charge capacity is equal to or less than the reference value and then to output a notification signal.

The reference value set to the reference value adjusting unit 102 is dynamically decided based on at least discharged energy within charged energy and discharged energy of the storage battery 11 during a predetermined time period. The battery management device 10 accordingly includes a demand management unit 104 configured to obtain (measure) charged energy and/or discharged energy of the storage battery 11.

The demand management unit 104 includes a power measuring unit 1041 configured to detect (measure) input or output energy of the storage battery 11 per unit time, and a history storage unit 1042 configured to store information of electric energy detected with the power measuring unit 1041. The demand management unit 104 further includes a demand estimation unit 1043 configured to estimate demand energy that requires to be charged in the storage battery 11 during a corresponding predetermined time period based on the information of electric energy stored in the history storage unit 1042. The demand estimation unit 1043 is configured to estimate how much residual of the storage battery 11 can satisfy electric energy to be consumed during the predetermined time period. A smallest value of electric energy in the range corresponds to the demand energy.

In general, many storage batteries increase in internal impedance if discharge and charge thereof are cyclically repeated. That is, as shown in FIG. 2, it is known that a full-charge capacity of a storage battery decreases according to increase in the number of discharge and charge cycles thereof. One discharge and charge cycle is defined by a time period during which the residual of the storage battery changes from full charge to zero, and a time period during which the residual of the storage battery changes from zero to full charge. However, in practical use of a storage battery, it hardly reaches full charge when it is charged, and the residual of the storage battery hardly decreases to 0 when the storage battery is discharged. That is, the power storage device 1 used for usage supplying electric power to the loads 4 is frequently used so as to repeat discharge and charge in an intermediate region when the residual of the storage battery 11 has a range of several tens %. However, even if it is taken into account, a full-charge capacity of the storage battery 11 is to gradually decrease according to increase in the number of discharge and charge repetitions thereof.

The embodiment regards, as degradation of the storage battery 11, decrease in a full-charge capacity of the storage battery 11 according to increase in the number of discharge and charge repetitions thereof, and sets a reference value with respect to the full-charge capacity, and judges that the storage battery 11 is at an end of its life if the full-charge capacity is equal to or less than the reference value. The battery management device 10 accordingly includes the capacity measuring unit 101 for measuring the full-charge capacity.

There are known various technologies for measuring a full-charge capacity of the storage battery 11. For example, by charging the storage battery 11 by known electric power for a time period during which the storage battery 11 is neither discharged nor charged, the full-charge capacity can be measured from a potential difference before and after the accumulation of electricity. As stated above, since a full-charge capacity of a storage battery decreases according to increase in internal impedance thereof, the full-charge capacity may be obtained by measuring the internal impedance from transient voltage waveforms to convert the measured internal impedance thereinto. As stated above, the internal impedance can be measured by measuring an open-circuit voltage when the storage battery 11 is neither discharged nor charged and then detecting transient voltage waveforms while turning on and off a load(s) of the storage battery 11. As a result, the full-charge capacity can be obtained. Known technologies can be applied to measurement of the full-charge capacity, and detailed explanation is accordingly omitted.

On the other hand, the reference value is dynamically decided according to usage status of the storage battery 11. A technology for deciding the reference value is hereinafter explained. In a specified usage application (a first usage application) in which demand energy can be decided, after measuring only a total amount of discharged energy from the storage battery 11 as usage status of the storage battery 11, from the total amount, the reference value can be dynamically decided based on the demand energy. In another usage application (a second usage application), it is necessary to measure both discharged energy from the storage battery 11 and charged energy into the storage battery 11, as usage status of the storage battery 11. In the case of the latter, if self-discharge is ignored, a difference between charged energy into the storage battery 11 and discharged energy from the storage battery 11 becomes a standard of the full-charge capacity. Monitoring of usage status of the storage battery 11 therefore requires a power sensor (not shown) for measuring discharged energy from the storage battery 11, or both discharged energy from the storage battery 11 and charged energy into the storage battery 11.

In the first and second usage applications, charged power into the storage battery 11 is obtained from the electric power system 2 or the photovoltaic power generator 3. In a case where electric power of the electric power system 2 is used, a charging time period of the storage battery 11 is decided by a unit price of electricity. In a case where electric power of the photovoltaic power generator 3 is used, a charging time period of the storage battery 11 is decided by a time period during which electricity can be generated. That is, the charging time period of the storage battery 11 substantially has a daily cycle as a cycle period. It is therefore desirable that the predetermined time period used for estimation of demand energy by the demand estimation unit 1043 be one day for example.

As a usage application of the first usage application, it is assumed that the storage battery 11 is charged only at night and the storage battery 11 is not charged in the daytime. That is, the usage application corresponds to a case where a charging time period and a discharging time period of the storage battery 11 are divided during the aforementioned one day as the predetermined time period. The usage application corresponds to the aforementioned usage applications (1) and (2). In this operation, the storage battery 11 is not charged but only discharged, in the daytime. Therefore, if a total amount of discharged energy form the storage battery 11 is obtained, demand energy can be obtained. As a result, the reference value can be decided. The reference value may be set to a value obtained by adding a margin to the demand energy.

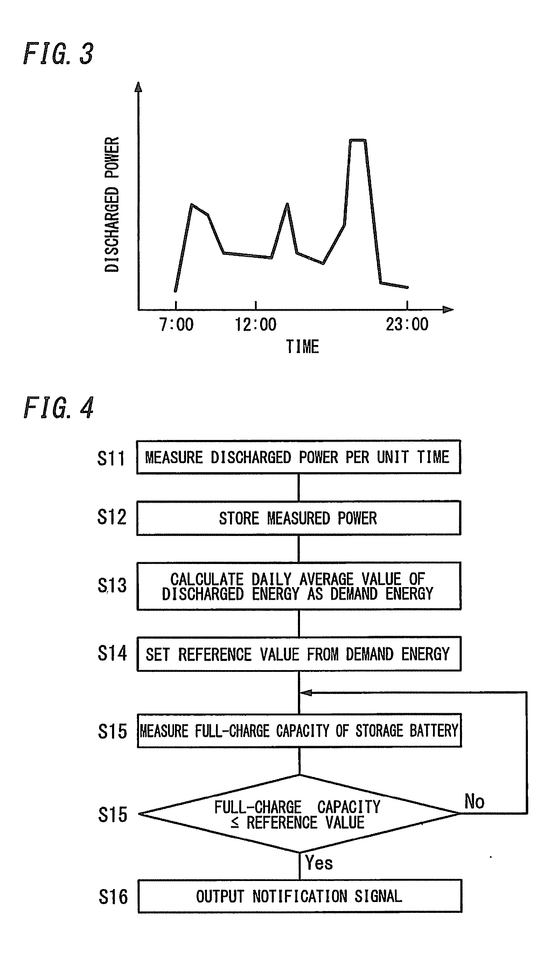

As shown in FIG. 3, information of a history of transition of discharged power from the storage battery 11 is therefore stored in the history storage unit 1042. Each electric power stored in the history storage unit 1042 actually corresponds to electric energy per unit time (e.g., one second, one minute or the like). The electric power is regarded as constant during the unit time and information of the electric energy is stored in the history storage unit 1042 along with a time stamp. The demand estimation unit 1043 calculates an integrated value, during the predetermined time period, of electric power stored in the history storage unit 1042 as a total amount of discharged energy from the power storage device 1. Since it is assumed that the storage battery 11 is not charged in the daytime, the total amount of electric energy obtained by integrating discharged energy during one day becomes a value for determining demand energy to be charged in the storage battery 11, as stated above.

In the example of the figure, it is assumed that a unit price of electricity changes in two steps of a time period from 7:00 to 23: 00 and a time period from 23:00 to next 7:00. The figure illustrates a case where the storage battery 11 is discharged in a time period from 7:00 to 23:00. The illustration of time periods is just one example. If time periods in which a unit price of electricity changes differ therefrom, it is necessary to integrate discharged power with respect to each of the time periods. In a case where a unit price of electricity changes in three steps depending on time periods, the storage battery 11 may be charged for a time period during which the unit price is a lowest price within the three steps, and discharged for a time period during which the unit price is a highest price, or for both the time period of the highest price and a time period of an intermediate price.

The demand energy obtained through the demand estimation unit 1043 is determined from discharged energy from the storage battery 11 for one day. In other words, the demand energy is electric energy to be charged in the storage battery 11 for one day. Therefore, if a full-charge capacity of the storage battery 11 is equal to or more than the obtained demand energy, it can satisfy discharged energy from the storage battery 11 for one day. That is, it is possible to judge a lifetime of the storage battery 11 by obtaining a reference value with respect to the full-charge capacity based on the demand energy obtained through the demand estimation unit 1043.

Discharged energy from the storage battery 11 for one day however fluctuates day by day. It is therefore desirable that the demand estimation unit 1043 be configured: to obtain, per day, discharged energy from the storage battery 11 for one day based on information of transition of electric power stored in the history storage unit 1042; and to obtain, as demand energy, a representative value of obtained discharged energy to decide a reference value. The representative value of discharged energy employed as the demand energy is selected from an average value, a median, a greatest value and the like of discharged energy from the storage battery 11 per day in a target period such as, for example, one week or one month.

In order that electricity received from the electric power system 2 for a time period during which a unit price of electricity is a high price can be reduced by using the power storage device 1 like the usage applications (1) and (2), it is desirable that a greatest value of discharged energy from the storage battery 11 be employed as the representative value. If the greatest value is employed, electric power of the storage battery 11 can be supplied to the loads 4 without receiving electric power from the electric power system 2. In a case where electric energy received from the electric power system 2 can be increased in order to lengthen time to replacement of the storage battery 11, an average value or a median of discharged energy from the storage battery 11 can be employed.

In a case where a daily difference of discharged energy from the storage battery 11 during the target period is small, the aforementioned time to replacement of the storage battery 11 can be secured even if the greatest value of discharged energy is employed. On the other hand, in a case where a difference of discharged energy from the storage battery 11 is expected to be large like that between a weekday and a day off, it is desirable that the average value or the median be employed because if the greatest value of electric energy is employed, the time to replacement of the storage battery 11 is to be shortened.

Setting of the reference value requires considering loss caused by discharge and charge of the storage battery 11 and a change in a full-charge capacity caused by temperature change. It is therefore desirable that the demand estimation unit 1043 correct the obtained demand energy to employ as a reference value for judging the lifetime. In the aforementioned operation, information of electric energy per unit time is stored by using the history storage unit 1042, and an integrated value of electric energy is used for obtaining demand energy. A configuration for performing only integration of electric energy may be therefore employed without using the history storage unit 1042. In this case, a function for integrating electric energy obtained per unit time may be provided in place of the history storage unit 1042.

FIG. 4 shows an operation of the battery management device 1. Discharged energy from the storage battery 11 is measured per unit time with the power measuring unit 1041 provided in the demand management unit 104 (S11). Information of the electric power obtained (measured) with the power measuring unit 1041 is stored in the history storage unit 1042 (S12). The demand estimation unit 1043 integrates electric energy derived from the information stored in the history storage unit 1042 to calculate an average value of discharged energy, per predetermined time period (one day) during the target period, of the storage battery 11 (S13). The reference value adjusting unit 102 estimates a full-charge capacity required for the storage battery 11 from electric energy (i.e., demand energy) calculated with the demand estimation unit 1043, and decides a reference value for judging a lifetime of the storage battery 11 based on the demand energy (S14).

The reference value adjusting unit 102 decides the reference value. The reference value is set to the reference value adjusting unit 102. In this state, the capacity measuring unit 101 measures a full-charge capacity of the storage battery 11 (S15). The output unit 103 compares the full-charge capacity estimated with the capacity measuring unit 101 and the reference value set to the reference value adjusting unit 102. The output unit outputs a notification signal when the full-charge capacity is equal to or less than the reference value (S16).

The battery management device 1 updates the reference value for judging the lifetime of the storage battery 11 at any time. Update timing of the reference value may be decided based on a comparatively long time interval such as monthly or seasonally.

The example of the aforementioned operation shows a case where charging time period and discharging time period of the storage battery 11 are divided, but there is also a case where charging time period and discharging time period of the storage battery 11 are not divided like the usage applications (3), (4) and (5). An operation example (the second usage application) in a case where charging time period and discharging time period of the storage battery 11 are mixed is hereinafter explained.

In this case, the power measuring unit 1041 detects (measures) charged energy and discharged energy of the storage battery 11 per unit time (e.g., one second, one minute or the like) and calculates residual of the storage battery as an output value of the power measuring unit 1041. The power measuring unit 1041 may individually output the charged energy and the discharged energy of the storage battery 11. However, if the residual of the storage battery is output, data processing can be easily performed just by dealing only one type of data.

Information of residual of the storage battery as the output of the power measuring unit 1041 is stored in the history storage unit 1042 along with a time stamp. Information of transition of the residual of the storage battery according to time passage is therefore stored in the history storage unit 1042. The demand estimation unit 1043 estimates a full-charge capacity required for the storage battery 11 from the transition of the residual of the storage battery in accordance with any one of the following methods,
(A) The demand estimation unit obtains maximum and minimum values of the residual of the storage battery, and judges the full-charge capacity required for the storage battery 11 from a maximum difference, during the predetermined time period, of differences each of which is obtained by subtracting a minimum value from a maximum value, which are adjacent to each other in a time axis. In this method, a maximum discharge amount is obtained while the storage battery 11 is repeatedly discharged and charged during the predetermined time period, so that the full-charge capacity required for the storage battery 11 can be reasonably estimated.
(B) The demand estimation unit judges the full-charge capacity required for the storage battery 11 from a difference between a greatest value and a smallest value of residual of the storage battery during the predetermined time period. In this method, charged energy into the storage battery 11 during the predetermined time period has a margin in comparison with the method (A). It is therefore possible to estimate a full-charge capacity with a margin so as to prevent shortage of charged energy into the storage battery 11 even when discharged energy is larger than usual.
(C) The demand estimation unit obtains maximum and minimum values of the residual of the storage battery, and judges the full-charge capacity required for the storage battery 11 from an average value, during the predetermined time period, of differences each of which is obtained by subtracting a minimum value from a maximum value, which are adjacent to each other in a time axis. Σ(Si-Ii)/n is obtained, where Si is a maximum value, Ii is a minimum value, i of each of them is an order of a value occurring during the predetermined time period, and n is the number of occurrences during the predetermined time period. In this method, charged energy into the storage battery 11 during the predetermined time period has a margin smaller than that in the method (A). It is however possible to keep a comparatively long lifetime of the storage battery 11 by setting the reference value based on a value obtained by the present method.

A needed full-charge capacity can be estimated in response to usage status of the storage battery 11 in accordance with any one of the methods. A reference value is then set to the reference value adjusting unit 102 like the aforementioned operation example. It is desirable that a representative value during a target period be employed as the reference value like the aforementioned operation example. The reference value set to the reference value adjusting unit 102 is compared with the full-charge capacity measured with the capacity measuring unit 101 like step S16 shown in FIG. 4. The output unit 103 outputs a notification signal representing that the storage battery 11 is at an end of its life when the full-charge capacity measured with the capacity measuring unit 101 is equal to or less than the reference value.

The notification signal output from the output unit 103 is transmitted to an external device. The external device notifies that the storage battery 11 is at an end of its life. In place of this configuration, the output unit 103 may include a function for notifying, by the notification signal, that the storage battery 11 is at an end of its life. As such the notification, at least one of visual notification by powering a notification light and audible notification by a notification sound may be employed. The notification signal may include a message for notifying storage battery's 11 life. In this case, the message may be presented by displaying characters and/or a figure for representing storage battery's 11 life on a dot matrix display or by outputting a message representing storage battery's 11 life by a voice.

The battery management device 10 may include a capacity determination unit 105 configured to determine a capacity of the storage battery 11 suitable for a user(s). The capacity determination unit 105 is configured to determine the capacity of the storage battery 11 based on demand energy obtained with the demand management unit 104 (or a reference value set to the reference value adjusting unit 102). In short, the capacity determination unit 105 determines the full-charge capacity corresponding to demand energy. The capacity determination unit 105 may not only determine the full-charge capacity of the storage battery 11 to be purchased but also select a storage battery 11 with a proper lifetime, as a product of the storage battery 11 suitable for a user. The capacity determination unit 105 may include a function for analyzing the information of the history stored in the history storage unit 1042 to select a product of the storage battery 11. A user may be notified of a capacity of the storage battery 11 determined with the capacity determination unit 105 or a product selected with the capacity determination unit 105 like the message for notifying storage battery's 11 life when the output unit 104 outputs the notification signal for notifying storage battery's 11 life.

Information on the storage battery 11 determined with the capacity determination unit 105 may be stored in any one of the battery management device 10 and the storage battery 11. In a case where the battery management device 10 includes a communication interface unit (not shown), information on products of the storage battery 11 may be taken from an external device through the communication interface unit. In this case, it is possible to obtain information on new products of the storage battery 11 from an external device operated by a management company to which management of the power storage device 1 is consigned.

The output unit 103 is configured to compare a full-charge capacity measured through the capacity measuring unit 101 with the reference value set to the reference value adjusting unit 102 to output a notification signal, but may be configured to perform a preliminary notification before outputting the notification signal. In this case, the output unit 103 is additionally provided with a function for comparing the full-charge capacity measured through the capacity measuring unit 101 with a preliminary reference value larger than the reference value, and to output a preliminary notification signal when the full-charge capacity is equal to or less than the preliminary reference value. The preliminary reference value may be automatically set to a value obtained by multiplying the reference value by a coefficient larger than 1 (e.g., 1.1), or a value obtained by adding a specified value to the reference value.

The preliminary notification signal output from the output unit 103 is used for notifying a user(s) of the storage battery 11 reaching an end of its life before long. It is therefore desirable that when the preliminary notification signal is output, a user is notified of the selected product type or the capacity of the storage battery 11 determined through the capacity determination unit 105. In this case, a user can order a storage battery 11 for replacement and perform replacement of the storage battery 11 without delay.

The output unit 103 does not necessarily use the notification signal and the preliminary notification signal for notification to a user(s). The output unit may transmit, by communication, the notification signal and the preliminary notification signal to an external device operated by a management company to which management of the power storage device 1 is consigned. In this case, since the management company is to manage a lifetime of the storage battery 11, it can recommend a storage battery 11 suitable for usage status of a user(s).

In the aforementioned operation examples, the reference value adjusting unit 102 sets the reference value based on usage status of the storage battery 11 and the information of the history stored in the history storage unit 1042. It may set a reference value as a standard value based on information such as family structure, scale of the loads 4, usage application of the power storage device 1, and the like.

In this case, the battery management device 10 needs an input unit for inputting such information. Examples of the input unit include a device added to the battery management device 10, and a device detachably connected to an interface unit (not shown) provided in the battery management device 10. Examples of the former include a touch panel, switches and the like. Examples of the latter include a personal computer, a tablet terminator, a smartphone and the like.

In the aforementioned embodiments, the battery management device 10 is embedded in the battery power conditioner 12. The battery management device 10 may be however provided separately from the battery power conditioner 12. For example, the storage battery 11 may be managed by adding the aforementioned function to an energy management apparatus configured to integrally manage usage of energy in a residence.

A first or second usage application may be previously determined at installation of a storage battery management device or the like and previously set to the storage battery management device. As another example, when a user selects any of the usage applications (1) to (5) through the aforementioned input unit, a first or second usage application may be automatically set to a storage battery management device in response to the selected usage application.

## Claims

1. A battery management device, comprising:
a capacity measuring unit configured to measure a full-charge capacity of a storage battery;
a demand management unit configured to obtain demand energy to be charged in the storage battery during a predetermined time period based on at least discharged energy within charged energy and discharged energy of the storage battery during the predetermined time period;
a reference value adjusting unit configured so that a reference value is dynamically set thereto based on the demand energy obtained through the demand management unit; and
an output unit configured
to compare the full-charge capacity measured with the capacity measuring unit and the reference value set to the reference value adjusting unit, and
to judge that the storage battery is at an end of its life if the full-charge capacity is equal to or less than the reference value and then to output a notification signal.

2. The battery management device of claim 1, wherein the demand management unit comprises:
a power measuring unit configured to obtain a time change in a residual of the storage battery from the charged energy and the discharged energy of the storage battery during the predetermined time period;
a history storage unit configured to store information of the time change in the residual of the storage battery obtained through the power measuring unit; and
a demand estimation unit configured to obtain the demand energy from the information of the time change in the residual of the storage battery stored in the history storage unit.

3. The battery management device of claim 2, wherein the demand estimation unit is configured to obtain, as the demand energy, a difference between a greatest value and a smallest value of the residual of the storage battery during the predetermined time period.

4. The battery management device of claim 1, wherein
the storage battery management device is adapted to an application in which a charging time period and a discharging time period of the storage battery during the predetermined time period are divided, and
the demand management unit is configured to obtain, as the demand energy, a total amount of discharged energy of the storage battery during the discharging time period of the storage battery within the predetermined time period.

5. The battery management device of claim 1, wherein the demand energy for determining the reference value is a daily average value of discharged energy of the storage battery within a prescribed target period.

6. The battery management device of any one of claims 1-5, further comprising a capacity determination unit configured to determine the full-charge capacity of the storage battery required for a user based on the demand energy obtained through the demand management unit,
wherein the output unit comprises a function for presenting the full-charge capacity of the storage battery determined with the capacity determination unit.

7. A storage battery management method for a storage battery management device configured to manage a lifetime of a storage battery, comprising:
obtaining demand energy to be charged in the storage battery during a predetermined time period based on at least discharged energy within charged energy and discharged energy of the storage battery during the predetermined time period;
dynamically setting a reference value based on the demand energy; and
comparing an estimated full-charge capacity of the storage battery and the reference value, and judging that the storage battery is at an end of its life if the full-charge capacity is equal to or less than the reference value and then to output a notification signal.

8. A program for making a computer function as a storage battery management device comprising:
a capacity measuring unit configured to measure a full-charge capacity of a storage battery;
a demand management unit configured to obtain demand energy to be charged in the storage battery during a predetermined time period based on at least discharged energy within charged energy and discharged energy of the storage battery during the predetermined time period;
a reference value adjusting unit configured so that a reference value is dynamically set thereto based on the demand energy obtained through the demand management unit; and
an output unit configured
to compare the full-charge capacity measured with the capacity measuring unit and the reference value set to the reference value adjusting unit, and
to judge that the storage battery is at an end of its life if the full-charge capacity is equal to or less than the reference value and then to output a notification signal.
